# DEMANDE DE BREVET EUROPEEN

(11) **EP 4 750 276 A1**
(43) Date de publication de la demande: **27.05.2026**
(21) Numéro de dépôt: 25215857.1
(22) Date de dépôt: 14.11.2025
(51) Int. Cl.: H10F 77/70, H10F 10/19

(54) **PROCEDE DE TEXTURATION DE SUBSTRATS EN SILICIUM**

(30) Priorité: 25.11.2024 FR 2412886
(71) Demandeur: Commissariat à l'Energie Atomique et aux Energies Alternatives, 75015 Paris (FR)
(72) Inventeur: LIGNIER, Hélène, 38054 GRENOBLE CEDEX 09 (FR); SALLABERRY, Ludovic, 38054 GRENOBLE CEDEX 09 (FR); ROUSSEAU, Sylvain, 38054 GRENOBLE CEDEX 09 (FR)
(74) Mandataire: Cabinet Beaumont

(57) **Abrégé**

La présente description concerne un procédé de texturation de substrats en silicium comprenant les étapes suivantes :
a) fournir :
- un premier substrat en silicium (100), comprenant une première face (101), recouverte par une couche d'oxyde (110), et une deuxième face (102), et
- un deuxième substrat en silicium (200) comprenant une première face (201), recouverte par une couche d'oxyde (210), et une deuxième face (202),

b) assembler le premier substrat (100) et le deuxième substrat (200) par collage direct hydrophile, en mettant en contact les couches d'oxyde (110, 210) des substrats (100, 200),
c) mettre en contact la deuxième face (102) du premier substrat (100) et la deuxième face (202) du deuxième substrat (200) avec une solution basique, moyennant quoi la deuxième face (102) du premier substrat (100) et la deuxième face (202) du deuxième substrat (200) sont texturées,
d) séparer les substrats (100,200).

## Description

### Domaine technique

La présente description concerne de façon générale le domaine des substrats en silicium, notamment des substrats en silicium et, en particulier, des substrats en silicium cristallin utilisés pour la fabrication de cellules photovoltaïques, en particulier les cellules photovoltaïques tandem, notamment les cellules tandem pérovskite sur silicium, utilisant une sous-cellule de structure variable (hétérojonction, TopCon) ou les cellules photovoltaïques à simple jonction telles que les cellules photovoltaïques à hétérojonction ou de type TopCon.

### Technique antérieure

Les cellules photovoltaïques tandem comprennent deux sous-cellules : une sous-cellule inférieure (ou 'Bottom Cell') et une sous-cellule supérieure ('Top Cell').

Les sous-cellules à hétérojonction, par exemple à hétérojonction de silicium, comprennent typiquement un substrat en silicium cristallin, recouvert de part et d'autre par une couche de silicium amorphe intrinsèque servant de couche de passivation puis par, d'un côté, une couche en silicium amorphe dopé n, et de l'autre côté par une couche en silicium amorphe dopé p.

La sous-cellule inférieure a généralement en face avant, exposée à la lumière, une face texturée et, en face arrière, une face polie.

La face arrière polie a une rugosité minimale pour permettre le dépôt en voie liquide des couches formant la sous-cellule supérieure. Le polissage peut être un polissage mécanochimique (CMP pour 'Chemical Mechanical Polishing').

La face texturée permet de récupérer un maximum de photons et ainsi gagner en courant, le courant étant directement lié au rendement de conversion.

La texturation est généralement réalisée par attaque chimique.

Pour pouvoir conserver une face polie et lisse, lors de la texturation, celle-ci est généralement recouverte par une couche de protection. Un tel procédé est, par exemple, décrit dans le document WO 2012/083944 A1. Le procédé comprend les étapes suivantes : polir la face avant et la face arrière d'un substrat en silicium, déposer une couche de protection, par exemple une couche de nitrure de silicium et/ou une couche d'oxyde de silicium, sur la face avant du substrat en silicium, texturer la face arrière du substrat en silicium au moyen d'une solution basique. La couche de protection est généralement déposée par PECVD. Elle retirée à la fin du procédé, par exemple, au moyen d'une solution de HF.

Le procédé présente plusieurs inconvénients :
- le dépôt de la couche barrière est chronophage et coûteux,
- la couche barrière doit être parfaitement homogène et suffisante pour ne pas générer de gravure locale,
- le dépôt par PECVD est généralement réalisé à 450°C, température à laquelle des défauts peuvent être générés dans le substrat en silicium (par exemple, dans des substrats Fz ('Float Zone'), des zones dites mortes ('dead zone') peuvent se former,
- il peut être source de contaminations métalliques.

Un tel procédé nécessite de retirer la couche barrière, après l'étape de texturation simple face, ce qui augmente le nombre d'étapes à réaliser et le coût. Par ailleurs, cette couche barrière doit être parfaitement gravée car la présence de résidu génèrerait des disfonctionnements à l'échelle de la future cellule tandem.

### Résumé de l'invention

Il existe un besoin d'avoir un procédé de fabrication permettant d'avoir un substrat en silicium, ayant une face polie et une face texturée, et remédiant au moins en partie aux inconvénients de l'art antérieur.

Ce but est atteint par un procédé de texturation de substrats en silicium, le procédé comprenant les étapes suivantes :
a) fournir :
   - un premier substrat en silicium, comprenant une première face polie, recouverte par une couche d'oxyde, et une deuxième face, et
   - un deuxième substrat en silicium comprenant une première face polie, recouverte par une couche d'oxyde, et une deuxième face,
b) assembler le premier substrat et le deuxième substrat par collage direct hydrophile, en mettant en contact les couches d'oxyde du premier substrat et du deuxième substrat,
c) mettre en contact la deuxième face du premier substrat et la deuxième face du deuxième substrat avec une solution basique, de préférence une solution de KOH, NaOH ou TMAH, moyennant quoi la deuxième face du premier substrat et la deuxième face du deuxième substrat sont texturées,
d) séparer le premier substrat du deuxième substrat.

Selon un mode de réalisation particulier, les couches d'oxyde sont des couches d'oxyde chimique, ayant de préférence une épaisseur comprise entre 0,8 nm et 1,8 nm, et de préférence entre 1,2 nm et 1,6 nm.

Selon un mode de réalisation particulier, les couches d'oxyde sont des couches d'oxyde thermique.

Selon un mode de réalisation particulier, l'oxyde thermique est formé en réalisant un traitement thermique à une température inférieure à 400°C, par exemple à une température comprise entre 150°C et 300°C.

Selon un mode de réalisation particulier, les couches d'oxyde sont des couches d'oxyde natif, ayant par exemple une épaisseur de 1 nm.

Selon un mode de réalisation particulier, lors de l'étape c), des éléments de maintien, par exemple des pinces ou des bagues, de préférence en polymère sont utilisés pour maintenir le premier substrat et le deuxième substrat l'un contre l'autre.

Selon un mode de réalisation particulier, la deuxième face du premier substrat et la deuxième face du deuxième substrat sont texturée sous forme de pyramides ayant une hauteur comprise entre 300 nm et 3 µm, de préférence, entre 1 et 2 µm.

Selon un mode de réalisation particulier, le premier substrat et le deuxième substrat sont obtenus par découpage d'un lingot de silicium au moyen d'un élément diamanté, par exemple un fil diamanté, des défauts, résultant de l'étape de découpe, présents sur la deuxième face du premier substrat et sur la deuxième face du deuxième substrat, pouvant être retirés par polissage dans une solution de KOH ayant, de préférence, une concentration supérieure à 30% massique.

Ce but est également atteint par un procédé de fabrication d'une cellule photovoltaïque, par exemple une cellule tandem ou une cellule à simple jonction, comprenant une étape au cours de laquelle un substrat en silicium est texturé en mettant en œuvre le procédé tel que décrit précédemment.

Selon un mode de réalisation particulier, la cellule tandem est une cellule comprenant une sous-cellule supérieure en pérovskite et une sous-cellule inférieure à base de silicium cristallin, formée à partir du substrat en silicium (100), la sous-cellule supérieure étant formée du côté de la première face (101) polie du substrat en silicium (100).

Selon un mode de réalisation particulier, la sous-cellule inférieure à base de silicium cristallin est une sous-cellule à hétérojonction ou une sous-cellule Topcon.

Selon un mode de réalisation particulier, la cellule tandem est une cellule de type p-i-n.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C et la figure 1D représentent, de manière schématique, différentes étapes d'un procédé de texturation simple face d'un substrat, selon un mode de réalisation particulier de l'invention ;
la figure 2 est un cliché photographique de la face polie d'un substrat, qui a été protégée par collage lors de l'étape de texturation, selon un mode de réalisation particulier de l'invention ;
la figure 3 est un cliché photographique de deux substrats assemblés par collage moléculaire et maintenus ensemble par un élément de maintien (des bagues), selon un autre mode de réalisation particulier de l'invention ;
la figure 4A est un cliché photographique de la face polie d'un substrat, qui a été protégée par collage lors de l'étape de texturation, selon un autre mode de réalisation particulier de l'invention ;
la figure 4B est un cliché photographique de la face texturée d'un substrat à l'issue du procédé de texturation selon un autre mode de réalisation particulier de l'invention ;
la figure 5 est un graphique représentant le rapport le rapport entre le temps de vie des porteurs de charge et la résistivité du matériau (rapport tau/rho) de différents substrats texturés;
la figure 6 est un graphique représentant la tension de circuit ouvert (Voc) de différents substrats texturés;
la figure 7 est un graphique représentant l'intensité de photoluminescence (signal PL) en nombre de coups de différents substrats texturés ;
la figure 8 représente plusieurs clichés obtenus par photoluminescence de différents substrats texturés.

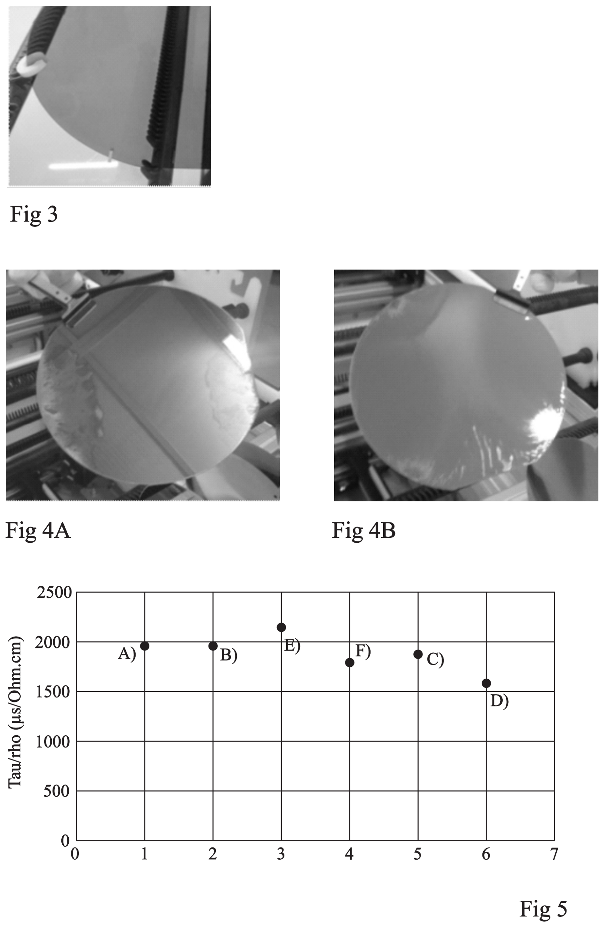

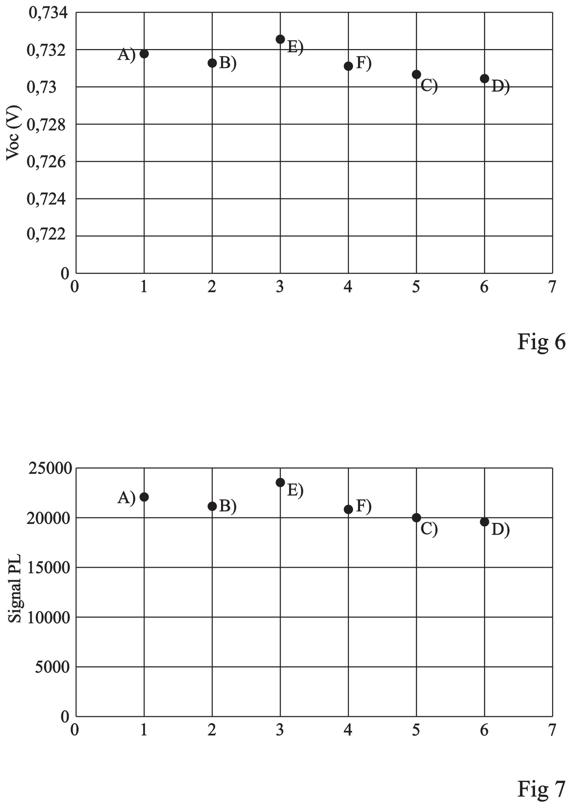

Sur les figures 5, 6, 7 et 8 :
- A) et B) correspondent à deux substrats dont les faces polies ont été protégées par une couche de SiN lors de l'étape de texturation (exemples donnés à titre comparatif)
- C) et D) correspondent à deux substrats dont les faces polies recouvertes d'un oxyde chimique ont été protégées par collage lors de l'étape de texturation, selon un autre mode de réalisation particulier de l'invention,
- E) et F) correspondent à deux substrats dont les faces polies recouvertes d'un oxyde natif ont été protégées par collage lors de l'étape de texturation, les substrats ayant été en outre maintenus l'un contre l'autre au moyen d'éléments de maintien (bagues en PTFE), lors de l'étape de texturation, selon un autre mode de réalisation particulier de l'invention.

Les différents éléments ne sont pas nécessairement représentés à une échelle uniforme pour rendre les figures plus lisibles.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 %, de préférence à 5 %.

Par transparent, on entend que la structure ou l'élément considéré a une transmittance supérieure ou égale à 70 %, de préférence supérieure ou égale à 80% et encore plus préférentiellement supérieure ou égale à 90%. La transmittance représente l'intensité lumineuse traversant l'élément ou la structure sur le spectre du visible. Elle peut être mesurée par spectrométrie UV-Vis-IR. La transmittance du spectre du visible correspond à la transmittance pour des longueurs d'ondes comprises entre 350 et 800 nm.

Par face polie ou face lisse, on entend une face ayant une rugosité moyenne arithmétique Ra inférieure à 2,5 nm, de préférence inférieure à 1 nm, et encore plus préférentiellement inférieure à 0,6 nm.

La rugosité Ra peut être déterminée par la mesure de Rdiffu ou R_{D} au moyen d'un spectrophotomètre. Pour cela, un faisceau incident illumine la surface de l'échantillon. La réflectivité diffuse R_{D} est égale au rapport de l'intensité de la lumière diffusée sur l'intensité du faisceau incident. Les intensités respectives du faisceau incident et de la lumière diffusée peuvent être mesurées par un ou plusieurs détecteurs photoélectriques. La réflectivité diffuse est une fonction strictement croissante de la rugosité de l'échantillon. Il est possible d'établir une loi de correspondance ou un abaque donnant la rugosité de l'échantillon en fonction de sa réflectivité diffuse.

Par face texturée, on entend une face structurée, recouverte par des éléments de texturation, par exemple des pyramides de 1 à 2 µm de hauteur. De préférence, il s'agit d'une structuration à l'échelle sub-micrométrique ou micrométrique. Les éléments de texturation ont, de préférence, une hauteur entre 300 nm et 3 µm.

Par compris entre X et Y, on entend que les bornes X et Y sont incluses.

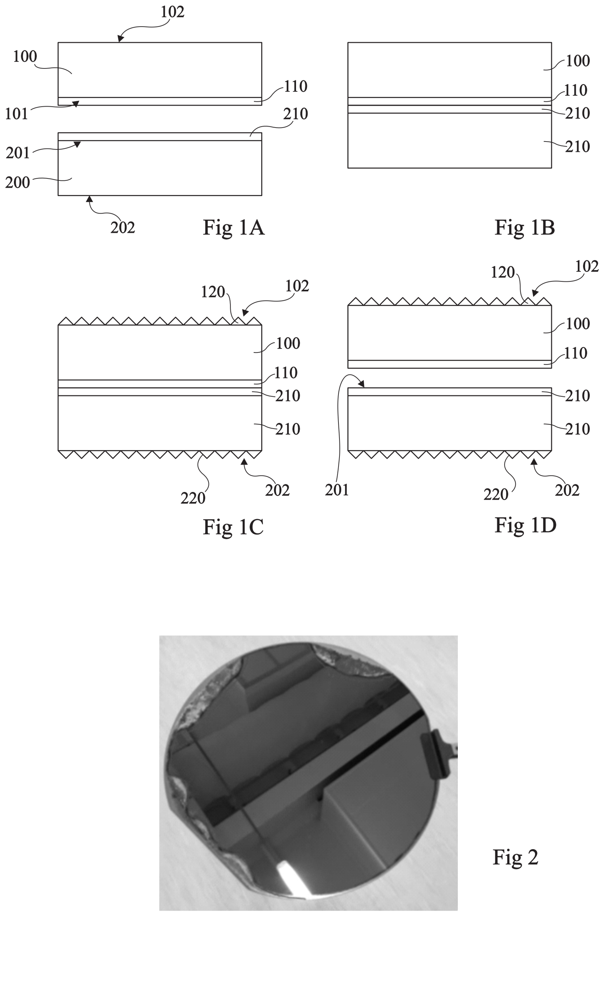

Nous allons maintenant décrire plus en détail le procédé de texturation simple face d'un substrat en silicium en faisant référence aux figures 1A à 1D. Le procédé comprend les étapes suivantes :
a) fournir :
   - un premier substrat 100 en silicium, comprenant une première face 101 et une deuxième face 102, la première face 101 du premier substrat 100 étant recouverte par une couche d'oxyde 110, et
   - un deuxième substrat 200 en silicium comprenant une première face 201 et une deuxième face 202, la première face 201 du deuxième substrat 200 étant recouverte par une couche d'oxyde 210,
b) assembler le premier substrat 100 et le deuxième substrat 200 par collage direct hydrophile, en mettant en contact les couches d'oxyde 110, 210 du premier substrat 100 et du deuxième substrat 200,
c) mettre en contact les deuxièmes faces 102, 202 du premier substrat 100 et du deuxième substrat 200 avec une solution basique, de préférence une solution d'hydroxyde de potassium (KOH), d'hydroxyde de sodium (NaOH) ou d'hydroxyde de tétraméthylammonium (TMAH), pour les texturer,
d) séparer le premier substrat 100 du deuxième substrat 200.

Le procédé est un procédé de texturation sélective. Il permet de texturer simultanément une face 102, 202 de chacun des substrats 100, 200. L'autre face 101, 201 des substrats 100, 200 est protégée par le collage moléculaire.

Le procédé permet de s'affranchir de l'étape de masquage (au moyen une couche de protection en SiNₓ ou SiOₓ déposée par PEVCD) couramment utilisée dans les procédés de l'art antérieur.

Le premier substrat 100 comprend une première face 101 et une deuxième face 102.

Le deuxième substrat 200 comprend une première face 201 et une deuxième face 202.

Les premières faces 101, 201 des substrats 100, 200 sont polies. Elles sont lisses : elles ont une rugosité quasi-nulle. Les substrats 100, 200 sont polis, par exemple, par CMP (poli miroir).

Les substrats 100, 200 fournis à l'étape a) sont des substrats à base de silicium. De préférence, il s'agit de substrats en silicium. Il s'agit, plus particulièrement, de substrat en silicium cristallin, de préférence en silicium monocristallin.

Les substrats sont, par exemple, des substrats de silicium Fz ('Float Zone').

Selon une variante de réalisation, les substrats sont des substrats en silicium obtenus par un procédé Cz (Czochralski) à partir de lingots de silicium qui sont sciés, par exemple avec des fils diamantés. De tels substrats sont moins coûteux que les substrats obtenus par un procédé Cz. Le sciage du lingot conduit à la formation de dommages à la surface du substrat découpé. Il est possible, en amont de l'étape b) de collage moléculaire, de graver la zone écrouie du substrat pour éliminer les dommages dus au sciage (étape dite SDR ou 'Saw Damage Removal') et obtenir une rugosité très faible en vue de la texturation. La gravure est, par exemple, réalisée au moyen d'une solution de KOH très concentrée (typiquement ayant une concentration supérieure à 30% massique, pendant une durée, par exemple, au moins 10 minutes). Des faces peu rugueuses sont ainsi obtenues, ce qui améliore le collage moléculaire.

Les substrats 100, 200 en silicium peuvent être dopés p ou dopés n, en fonction de l'application recherchée.

La première face 101 du premier substrat 100 et la première face 201 du deuxième substrat 200 sont recouvertes chacune par une couche d'oxyde 110, 210.

Les oxydes peuvent être des oxydes natifs. Un oxyde natif a une épaisseur, par exemple, de 10 Å.

Les oxydes peuvent être des oxydes chimiques. Un oxyde chimique a une épaisseur par exemple de 12 à 16 Å. Un oxyde chimique peut être formé en mettant la surface à oxyder en contact avec une solution acide. Par exemple, il peut s'agir d'une solution de DIO₃, HF/HCl/DIO₃, H₂O₂/HCl ou H₂SO₄/H₂O₂ (avec DIO₃ un mélange d'eau déionisée et d'ozone).

Les oxydes peuvent être des oxydes thermiques. Un oxyde thermique a une épaisseur par exemple de 10 à 900 nm. Un oxyde thermique peut être formé dans un four d'oxydation. De préférence, il est formé à une température inférieure à 400°C. Les oxydes thermiques permettent d'obtenir un collage fort entre les surfaces à coller. En utilisant des oxydes thermiques à la place des oxydes natifs, l'interface de collage est plus forte, ce qui limite les risques d'infiltration de la solution de gravure entre les substrats 100, 200, et donc réduit le pourcentage de surface défectueuse sur les premières faces 101, 201 (c'est-à-dire le pourcentage de surface texturée alors que la surface devrait restée polie) .

Une couche d'oxyde chimique ou une couche d'oxyde thermique diffère d'une couche d'oxyde natif à la fois par son épaisseur (la couche d'oxyde natif est beaucoup plus fine que la couche d'oxyde thermique) et par sa stœchiométrie.

Il est également possible d'utiliser un premier substrat 100 avec un oxyde natif et un deuxième substrat 200 avec un oxyde chimique ou un oxyde thermique (ou inversement), ou encore un premier substrat 100 avec un oxyde thermique et un deuxième substrat 200 avec un oxyde chimique (ou inversement).

Lors de l'étape b), les substrats 100, 200 sont ensuite assemblés deux à deux. L'assemblage est réalisé par collage moléculaire en mettant en contact les deux couches d'oxyde 110, 210. Les forces attractives entre les deux surfaces sont ainsi assez élevées pour provoquer une adhérence moléculaire. Le collage moléculaire est induit initialement par l'ensemble des forces attractives (forces de Van der Waals) d'interaction électronique entre atomes ou molécules des deux surfaces à coller. Le collage est ici un collage de surface hydrophile. Des interactions par liaison hydrogène (plus fortes que l'interaction de Van der Waals) sont également mises en jeu car les surfaces contiennent des atomes électronégatifs (donc présentant une affinité pour les électrons) liés à des atomes d'hydrogènes.

Il est possible de réaliser une étape de traitement thermique et/ou de réaliser le collage sous vide pour améliorer le collage.

La première face 101 du premier substrat 100 et la première face 201 du deuxième substrat 200 sont ainsi disposées au sein de l'assemblage et protégées lors de l'étape c).

Lors de l'étape c), la deuxième face 102 du premier substrat 100 et la deuxième face 202 du deuxième substrat 200 sont mises en contact avec une solution de gravure afin de les texturer. La gravure étant une gravure anisotrope, celle-ci conduit à la formation de motifs à la surface des deuxièmes faces 102, 202 des substrats 100, 200.

Les motifs 120, 220 de la texturation ont une hauteur, de préférence, comprise entre 300 nm et 3um, par exemple entre 1 et 2 µm.

De préférence, la gravure va conduire à la formation de pyramides sur les faces « libres » (i.e. les premières faces) des substrats 100, 200.

Les faces collées 101, 201 n'étant pas en contact avec la solution de gravure, elles ne seront pas texturées et resteront lisses.

La solution de gravure est une solution basique. De préférence, il s'agit d'une solution comprenant un dérivé d'hydroxyde. On choisira, par exemple, une solution de KOH, de TMAH ou de NaOH. De préférence, une solution de KOH est utilisée. Elle peut avoir une concentration comprise entre 0,5 et 4% massique. La solution peut en outre comprendre des surfactants. La concentration en surfactant est, par exemple, comprise entre 0,25 et 5% massique. Les surfactants permettent de modifier la tension de surface et ainsi faciliter l'évacuation des bulles d'hydrogène générées par la gravure du silicium en milieu basique. Les bulles d'hydrogène ne masquant plus la surface, on aura un maximum de sites de nucléation et donc une surface homogène. La texturation (notamment la génération de pyramides) se fera plus facilement et de manière plus homogène.

Lors de l'étape c) de texturation, et éventuellement lors de l'étape b), des éléments de maintien peuvent être utilisés pour tenir mécaniquement les substrats l'un contre l'autre. Ceci peut permettre d'éviter les infiltrations de solution de gravure par les bords des substrats 100, 200 au niveau de l'interface de collage.

Les éléments de maintien peuvent être des pinces ou des bagues.

Les éléments de maintien sont en un matériau inerte vis-à-vis de la solution de gravure et ne générant pas de contamination (contamination métallique notamment). Ils sont, par exemple, en polymère et notamment en polymère fluoré tel que le polytétrafluoroéthylène (PTFE) ou le perfluoroalkoxy (PFA).

Lors de l'étape d), le premier substrat 100 et le deuxième substrat 200 sont séparés. Cette étape peut être réalisée avec une précelle ou avec un jet de gaz inerte, par exemple un jet d'azote. Le moyen utilisé dépendra, par exemple, de la nature des oxydes collés.

Une étape de retrait de la couche d'oxyde peut être mise en œuvre.

Les substrats en silicium 100, 200 ainsi texturés peuvent être utilisés pour fabriquer des cellules photovoltaïques en configuration tandem (Silicium / pérovskite par exemple) ou, de manière plus générale, des cellules solaires multi-jonction (par exemple Si/PK/PK).

La cellule photovoltaïque en configuration tandem est, par exemple, une cellule comprenant une sous-cellule supérieure en pérovskite et une sous-cellule inférieure à base de silicium cristallin, formée à partir du substrat en silicium.

A titre d'exemple, la cellule solaire peut être une cellule tandem silicium pérovskite de type p-i-n comprenant une sous-cellule supérieure, par exemple en pérovskite, et une sous-cellule inférieure à hétérojonction de silicium. L'éclairement d'un dispositif tandem Si/PK est réalisé à partir de la sous-cellule à base de pérovskite.

Les deux sous-cellules peuvent être séparées par une couche intermédiaire électroniquement conductrice ou semiconductrice, de préférence transparente au rayonnement électromagnétique, par exemple en un TCO (oxydes conducteurs transparents) notamment en ITO (oxyde d'indium-étain).

La sous-cellule à hétérojonction de silicium comprend, par exemple, depuis la couche intermédiaire ou depuis la sous-cellule à base de pérovskite :
- une couche en silicium amorphe dopé n,
- de préférence une couche à base de silicium amorphe intrinsèque servant de couche en passivation,
- le substrat en silicium 100 cristallin dopé n, texturé selon le procédé précédemment décrit,
- de préférence, une couche à base de silicium amorphe intrinsèque servant de couche en passivation,
- une couche en silicium amorphe dopé p,
- une couche transparente, par exemple en ITO, et une métallisation, par exemple en argent, en cuivre ou en Ag/Cu.

La deuxième face 102 texturée du substrat de silicium 100 est en regard de la couche en silicium amorphe dopé p et la première face 101 polie du substrat de silicium 100 est en regard de la couche en silicium amorphe dopé n.

Par exemple, la sous-cellule à base de pérovskite comprend successivement depuis la face supérieure face exposée au soleil :
- une électrode dite électrode supérieure de préférence transparente,
- une couche conductrice de type n,
- une couche active en pérovskite,
- une couche conductrice de type p.

La sous-cellule inférieure à base de silicium cristallin est formée à partir du substrat en silicium. La sous-cellule supérieure est formée du côté de la face 101 polie du substrat.

Par exemple, les cellules tandem peuvent être fabriquées selon les étapes suivantes :
- texturer un substrat en silicium 100 de type n, par exemple de taille 6 pouces (soit 15,24 cm), selon le procédé précédemment décrit,
- déposer, par exemple, par PECVD des couches de a-Si :H intrinsèques et dopées (n ou p selon la face) de part et d'autre du substrat en silicium,
- déposer le TCO, par exemple de l'ITO, en face arrière (i.e. sur la première face texturée) et éventuellement l'ITO de recombinaison en face avant (i.e. sur la deuxième face polie) par exemple par PVD,
- déposer l'électrode (par exemple en Ag) en face arrière par exemple par évaporation thermique sous vide,
- former la sous-cellule supérieure en pérovskite en face avant en déposant successivement les différentes couches de la sous-cellule supérieure en pérovskite.

Le substrat en silicium texturé peut aussi être utilisé pour fabriquer des cellules photovoltaïques à technologie TopCon ou PERC ou encore pour des structures « CARLAH » ('Conductive Anti-Reflective LAyer for High temperature heterojunction') à contacts passivés. Exemples illustratifs et non limitatifs

Dans un premier temps, des substrats ('wafers') de silicium de 6 pouces (soit 15,24 cm) ont été polis par CMP en face avant et en face arrière. Une couche d'oxyde est formée à leur surface.

Dans le cas de l'oxyde natif, les substrats sont laissés à l'air libre dans un environnement propre.

Dans le cas de l'oxyde chimique, ils sont trempés dans un bain d'eau déionisée contenant de l'ozone DI-O₃ (20 à 40 ppm d'O₃) pendant quelques minutes (2 à 4 minutes) pour permettre la formation de cet oxyde.

La couche d'oxyde formée sur les substrats est extrêmement mince (10 à 16 Å).

Les substrats sont ensuite assemblés deux à deux par collage moléculaire. Pour cela, ils sont placés l'un au-dessus de l'autre, puis mis en contact physique l'un avec l'autre. Un appui local sur les bords du substrat supérieur à l'aide d'une précelle permet de maximiser le collage. Cette étape peut être réalisée sous vide pour améliorer le collage. Un traitement thermique peut être mis en œuvre.

Une fois assemblés, les substrats sont texturés : ils sont placés dans un panier de chimie puis trempés dans une solution basique. La solution contient du KOH (concentration supérieure à 1% massique) et des additifs (concentration supérieure à 0.2% massique). La température de la solution est supérieure à 70°C et inférieure à 95°C. Les substrats sont ensuite rincés et nettoyés en voie acide.

Après l'étape de texturation, une précelle est utilisée pour séparer les substrats.

Après séparation des substrats, il a été observé que les faces « libres » qui étaient en contact avec la solution de KOH étaient texturées alors que les faces collées ne sont pas texturées et restent lisses.

Pour les substrats avec l'oxyde natif, seules quelques zones, sur les surfaces en contact l'une avec l'autre, ont été légèrement détériorées suite à une légère pénétration de la chimie de gravure (voir zones entourées sur la figure 2). Le substrat présente moins de 5% de défectivité.

En utilisant des éléments de maintien pour maintenir mécaniquement les deux substrats et fermer l'interface de collage, le pourcentage de surface défectueuse (c'est-à-dire texturée alors que la surface devrait restée polie) est réduit.

A titre illustratif, la figure 3 représente deux substrats, dont la première face est recouverte d'oxyde natif, collés l'un à l'autre par collage moléculaire et maintenus l'un à l'autre par des éléments de maintien (des bagues en PTFE). La figure 4A représente, après séparation des substrats, une des faces qui était collée. En revanche, ces bagues peuvent gêner localement la texturation et modifier légèrement la fluidique locale (figure 4B).

Des essais comparatifs ont été réalisés en réalisant l'étape de texturation sur deux substrats positionnés l'un contre l'autre, non collés l'un à l'autre, et maintenus ensemble uniquement par des bagues en Téflon. Un maintien physique seul (via les bagues en téflon) ne permet pas une texturation simple face : la chimie s'insère sur les faces internes et les deux faces de chaque substrat se retrouvent texturées à l'issue du procédé.

En utilisant des oxydes thermiques à la place des oxydes natifs, le pourcentage de surface défectueuse est réduit, même sans utiliser d'éléments de maintien.

A l'issue de ce procédé de texturation simple face (avec mise en œuvre d'un collage moléculaire), les substrats décollés ont été passivés par PECVD (avec des couches nanométriques de silicium amorphes dopées).

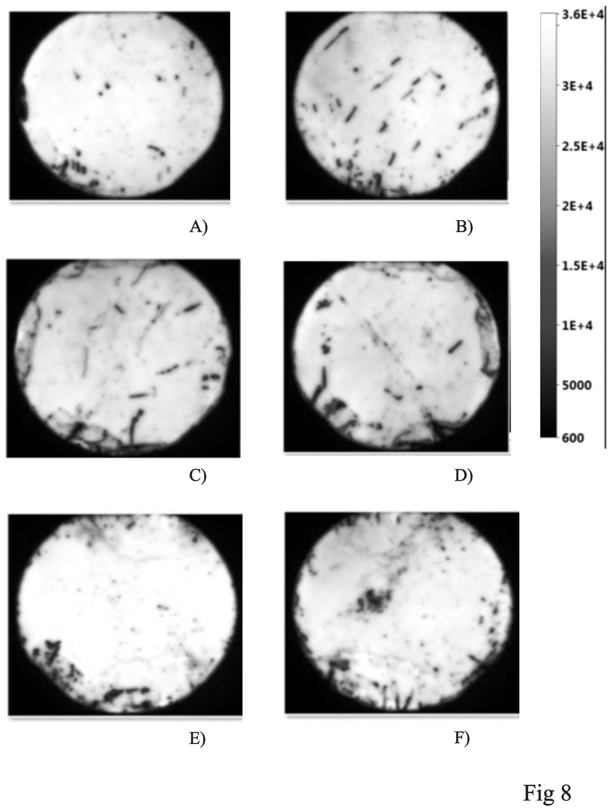

Différentes propriétés des substrats ainsi texturés ont ensuite été mesurées et comparées aux propriétés de substrats texturés simple face avec la méthode classique utilisant une couche barrière de nitrure de silicium. En particulier, les durées de vie ont été mesurées par IC-PCD ('Inductively Coupled Photo-Conductance Decay') au centre des substrats. Les résultats sont représentés sur les figures 5, 6 et 7. Des images de photoluminescence ont également été réalisées et permettent de mettre en évidence l'homogénéité de la durée de vie des porteurs minoritaires sur l'ensemble de la surface des substrats collés (figure 8).

Ces résultats permettent de mettre en évidence l'intérêt de ce procédé de texturation simple face. Le procédé, en plus de présenter de nombreux avantages liés à sa mise en œuvre, permet d'obtenir des dispositifs ayant d'excellents niveaux de passivation. Les niveaux de passivation sont similaires à ceux obtenus par le procédé de référence avec couche barrière.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Procédé de fabrication d'une cellule photovoltaïque au cours duquel une face (102) d'un substrat en silicium (100) est texturée selon les étapes suivantes :
a) fournir :
- un premier substrat en silicium (100), comprenant une première face (101) polie, recouverte par une couche d'oxyde (110), et une deuxième face (102), et
- un deuxième substrat en silicium (200) comprenant une première face (201) polie, recouverte par une couche d'oxyde (210), et une deuxième face (202),
b) assembler le premier substrat (100) et le deuxième substrat (200) par collage direct hydrophile, en mettant en contact les couches d'oxyde (110, 210) du premier substrat (100) et du deuxième substrat (200),
c) mettre en contact la deuxième face (102) du premier substrat (100) et la deuxième face (202) du deuxième substrat (200) avec une solution basique, de préférence une solution de KOH, NaOH ou TMAH, moyennant quoi la deuxième face (102) du premier substrat (100) et la deuxième face (202) du deuxième substrat (200) sont texturées,
d) séparer le premier substrat (100) du deuxième substrat (200).

2. Procédé selon la revendication 1, dans lequel les couches d'oxyde (110, 210) sont des couches d'oxyde chimique, ayant de préférence une épaisseur comprise entre 0,8 nm et 1,8 nm, et de préférence entre 1,2 nm et 1,6 nm.

3. Procédé selon la revendication 1, dans lequel les couches d'oxyde (110, 210) sont des couches d'oxyde thermique.

4. Procédé selon la revendication précédente, dans lequel l'oxyde thermique est formé en réalisant un traitement thermique à une température inférieure à 400°C, par exemple à une température comprise entre 150°C et 300°C.

5. Procédé selon la revendication 1, dans lequel les couches d'oxyde (110, 210) sont des couches d'oxyde natif, ayant, par exemple, une épaisseur de 1 nm.

6. Procédé selon l'une des revendications précédentes, dans lequel, lors de l'étape c), des éléments de maintien, par exemple, des pinces ou des bagues, de préférence en polymère sont utilisés pour maintenir le premier substrat (100) et le deuxième substrat (200) l'un contre l'autre.

7. Procédé selon l'une des revendications précédentes, dans lequel la deuxième face (102) du premier substrat (100) et la deuxième face (202) du deuxième substrat (200) sont texturée sous forme de pyramides (120, 220).

8. Procédé selon la revendication 7, dans lequel les pyramides (120, 220) ont une hauteur comprise entre 300 nm et 3 µm, de préférence, entre 1 et 2 µm.

9. Procédé selon l'une des revendications précédentes, dans lequel le premier substrat (100) et le deuxième substrat (200) sont obtenus par découpage d'un lingot de silicium au moyen d'un élément diamanté, par exemple un fil diamanté, des défauts, résultant de l'étape de découpe, présents sur la deuxième face (102) du premier substrat (100) et sur la deuxième face (202) du deuxième substrat (200), pouvant être retirés par polissage dans une solution de KOH ayant, de préférence, une concentration supérieure à 30% massique.

10. Procédé selon l'une des revendications précédentes, dans lequel la cellule photovoltaïque est une cellule tandem.

11. Procédé selon la revendication précédente, dans lequel la cellule tandem est une cellule comprenant une sous-cellule supérieure en pérovskite et une sous-cellule inférieure à base de silicium cristallin, formée à partir du substrat en silicium (100), la sous-cellule supérieure étant formée du côté de la première face (101) polie du substrat en silicium (100).

12. Procédé selon la revendication précédente, dans lequel la sous-cellule inférieure à base de silicium cristallin est une sous-cellule à hétérojonction ou une sous-cellule Topcon.

13. Procédé selon l'une des revendications 10 à 11, dans lequel la cellule tandem est une cellule de type p-i-n.
